Europäisches Patentamt

European Patent Office

Office européen des brevets

(19)

(11) EP 0 659 288 B1

(12) EUROPEAN PATENT SPECIFICATION

(45) Date of publication and mention
of the grant of the patent:
**30.05.2001 Bulletin 2001/22**

(51) Int Cl.$^7$: **G05B 13/02**, H03B 29/00

(21) Application number: **92915843.4**

(22) Date of filing: **14.07.1992**

(86) International application number:
**PCT/US92/05772**

(87) International publication number:
**WO 94/01810 (20.01.1994 Gazette 1994/03)**

(54) **LOW COST CONTROLLER**

PREISGÜNSTIGER REGLER

UNITE DE COMMANDE PEU COUTEUSE

(84) Designated Contracting States:
**AT BE CH DE DK ES FR GB GR IT LI LU MC NL SE**

(43) Date of publication of application:
**28.06.1995 Bulletin 1995/26**

(73) Proprietor: **NOISE CANCELLATION
TECHNOLOGIES, INC.
Linthicum, MD 21090 (US)**

(72) Inventors:
• **ZIEGLER, Eldon
  Columbia, MD 21045 (US)**
• **SMITH, Dexter
  Columbia, MD 21046 (US)**
• **MCLOUGHLIN, Michael
  Sykesville, MD 21784 (US)**

(74) Representative: **Wilhelm & Dauster
Patentanwälte European Patent Attorneys
Hospitalstrasse 8
70174 Stuttgart (DE)**

(56) References cited:
| | |
|---|---|
| **EP-A- 0 265 097** | **EP-A- 0 471 290** |
| **EP-A- 0 479 367** | **EP-A- 0 486 180** |
| **US-A- 4 566 118** | **US-A- 4 649 505** |
| **US-A- 4 878 188** | **US-A- 5 105 377** |
| **US-A- 5 219 037** | |

**EP 0 659 288 B1**

**Description**

Present invention relates to a low cost active noise control system for cancelling band-limited random noise in a physical plant, comprising a speaker means which, responsive to a control signal, generates a sound field thereby producing a residual noise equal to the sum of said sound field and said band-limited random noise and an error sensing means which senses the residual noise and generates a residual signal representative of said residual noise.

US-A 4 649 505 discloses a two-input crosstalk-resistant adaptive noise canceller. It receives on a first input a desired speech signal portion and an undesired noise signal portion and on a second input a reference input signal having a reference noise input portion and a crosstalk speech portion. A noise noise-free speech signal is obtained out of the signal at the first input by subtracting from it a filtered second input signal.

US-A 5 219 037 discloses a component mount assembly providing active control of vehicle vibration. It provides a system in which e.g. an engine of a car may be mounted in a vehicle such that the vibrations caused by the running engine do not or only very little transmit to the rest of the vehicle. This system comprises one or more sensors which feed data to a controller means. The controller means analyzes the vibrations to determine the harmonics thereof. The controller then constructs one or more output waveforms and feeds them to the actuator to produce the noise suppression and operates the actuator in response to the sensed vibration to avoid or cancel it.

A motivation of the present invention is the need for very low cost electronics in using active noise cancellation for quieting small fans, refrigerators and other extremely cost-sensitive applications.

The instant invention has the ability to cancel stationary random noise such as that encountered on a rangehood fan or tonal noise. The "plant" of the operation, i.e., the speakers, enclosure, microphone and the configuration itself has to be of a certain design so as to minimize delays which interfere with the plants ability to produce a cancellation signal. These delays are the result of the response of the loudspeaker, its cabinet and the transit time between speaker and microphone. While repetitive compensating techniques can be used in repetitive noise, they don't work with random noise. This invention contemplates employing strict design criteria in designing the "plant" and using equalizing filters. The equalization filter allows for a relaxation of the strict time delay requirements. A filter is used to produce an estimate of the noise by subtracting the predicted effects of the cancellation signal from the residual signal. For tonal cancellation the equalization filter is used to add additional delays at frequencies where needed, for instance where the plant delay is too long to meet the requirements for random cancellation, in order to meet an earlier cycle of the tonal noise. For random cancellation the equalization filter minimizes the mean-square error resulting from twin delays in the system.

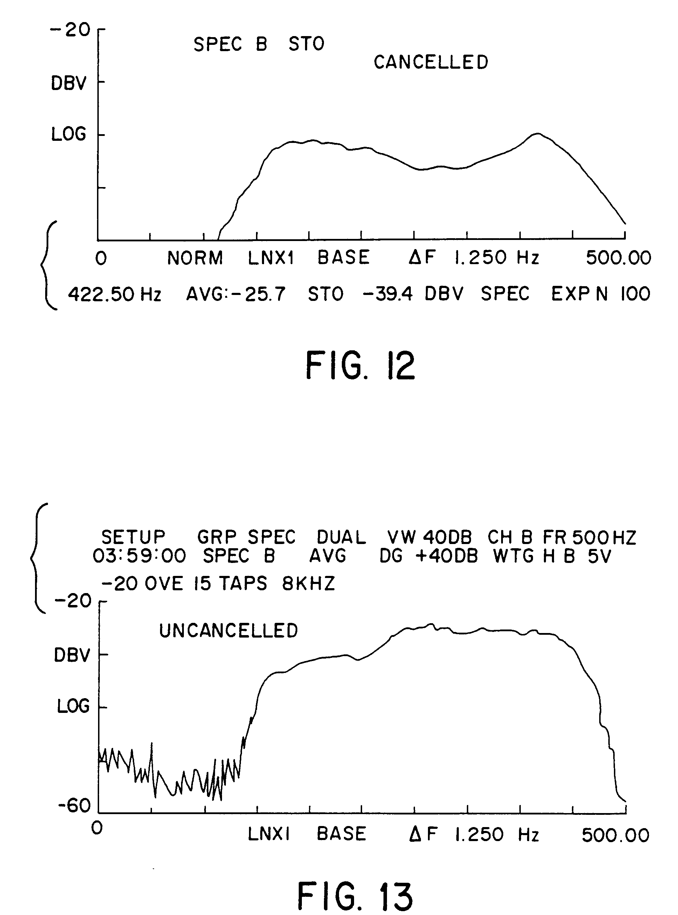

The DVE (digital virtual earth) system disclosed in U.S. Patent No. 5,105,377 can, with a dozen or so taps, cancel band limited random noise if plant delays are small enough. This has been done by canceling random noise limited between 150Hz to 450 Hz shown in the charts of Figs. 12 and 13 herein. The adaptive FIR filter of DVE can be replaced by a single inverting amplifier with adjustable gain under appropriate plant criteria. Thus a small, low cost canceller consists of a single filter to predict the effects of the cancellation signal on the residual signal enabling the feedback to be electronically subtracted. An inverting amplifier with adjustable gain is used and, possibly, an equalization circuit is used to compensate for delays in the plant that are too long for random cancellation when applying the device to tonal cancellation. The DYE feedback filter can be replaced with a simple delay resulting in a cancellation system including equalization that requires only a single filter.

Accordingly it is an object of this invention to provide an active noise cancellation plant system that can cancel band limited random noise.

Another object of this invention is to provide a low cost active noise cancellation system.

A further object of this invention is to provide an active noise cancellation system that can cancel tonal noise.

These and other objects will become apparent when reference is had to the accompanying description and drawings in which

Fig. 1 shows a circuit diagram of a basic standard controller set.

Fig. 2 shows a circuit of a basic controller simplified per this invention.

Fig. 3 is a circuit diagram showing a basic/weight optimum filter circuit.

Fig. 4 is a circuit diagram showing a weight optimum filter with an equalizer.

Fig. 5 is illustrative of a circuit showing equalizer training position.

Fig. 6 is a diagram showing an alternate equalizer position.

Fig. 7 shows a canceller with plant equalization.

Fig. 8 shows a diagram of a basic low cost canceller.

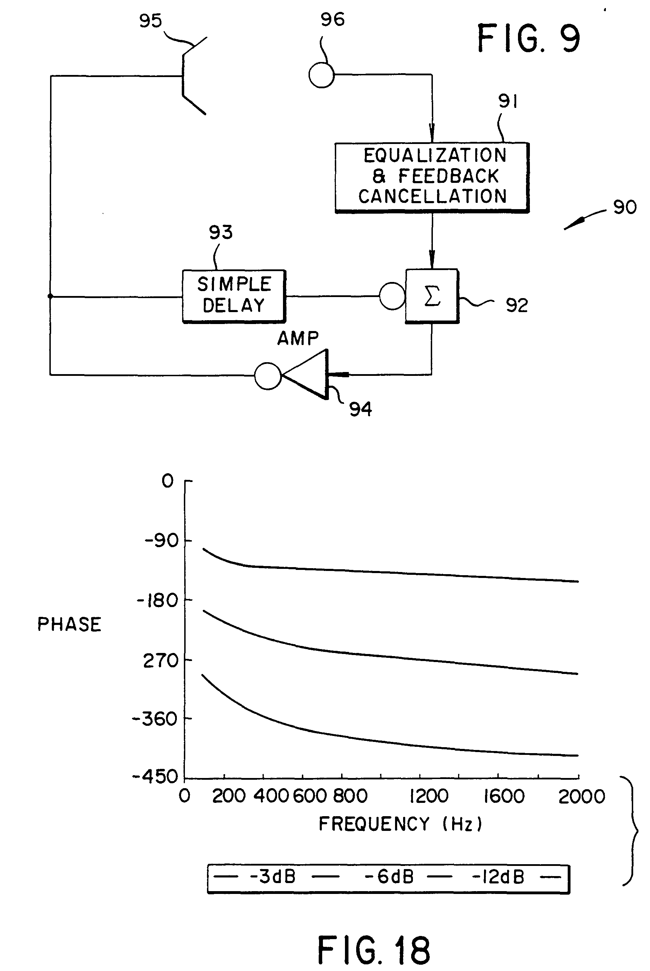

Fig. 9 shows a single filter low cost canceller with equalization.

Fig. 10 shows a plot of random noise cancellation in a SAAB twin prop.

Fig. 11 shows the plot of random noise cancellation in a Grumman Tiger single prop.

Figs. 12 and 13 show the results of fan noise cancellation with DVE cancellation On and Off.

Figs. 14 and 15 shows the amount of cancellation without equalization plotted for various frequencies and time delays.

Fig. 16 shows the value of Aopt without equalization for various frequencies and time delays.

Fig. 17 shows the plot of solving for maximum plant delay at various frequencies, and

Fig. 18 shows the required phase response for three different levels of cancellation.

Plant delays prevent an active cancellation system from using perfect knowledge of the noise to produce the cancellation signal. Plant delays in acoustic systems often result from the response of the loudspeaker, its cabinet and the transit time between the speaker and microphone. These delays can be compensated for when canceling repetitive noise. However, these repetitive compensating techniques do not work with random noise.

Insight into the effects of plant delays on random noise cancellation and the resulting optimum plant design can be obtained from an analysis of a simple active canceller in which the noise is known and is sinusoidal but use is not made of sinusoidal compensation techniques.

The Active Canceller Model

When the noise is known a simple active canceller can be used consisting of an inverting amplifier with adjustable gain. If the noise is

$$n(t) = \sin(\omega t), \qquad \text{Eq. (1)}$$

where $\omega$ is the frequency in radians per second, then the optimum cancellation signal is

$$c(t) = -A |H| \sin(\omega t - w t_d) \qquad \text{Eq. (2)}$$

where A is the gain, $|H|$ is the magnitude of the plant response at frequency $\omega$ and $t_d$ is the plant delay, in seconds, at frequency $\omega$. The residual signal is

$$r(t) = \sin(\omega t) - A |H| \sin(\omega t - \omega t_d) \qquad \text{Eq. (3)}$$

and the average power of the residual is given by

$$P = 0.5 [1 - 2 A |H| \cos(\omega t_d) + A^2 |H|^2] \qquad \text{Eq. (4)}$$

Plant Design Requirements

Taking the partial derivative of equation 4 with respect to A and solving; the optimal value of A is

$$A_{opt} = \frac{\cos(\omega t_d)}{|H|} \qquad \text{Eq. (5)}$$

Note that the optimal gain depends on the frequency, the amount of delay and the magnitude of the frequency response. In order for $A_{opt}$ to be independent of frequency the right hand side of equation 5 must be constant. If the plant has a flat frequency response the product $\omega t_d$ must be constant. This implies that the phase decreases proportionately to the log of the frequency.

The amount of cancellation is computed by dividing by the power of the original signal (0.5) giving

$$dB = 10 \log [1 - 2 A |H| \cos(\omega t_d) + A^2 |H|^2] \qquad \text{Eq. (6)}$$

or

$$dB_{opt} = 10 \log \sin^2(\omega t_d) \qquad \text{Eq. (7)}$$

with a flat frequency response

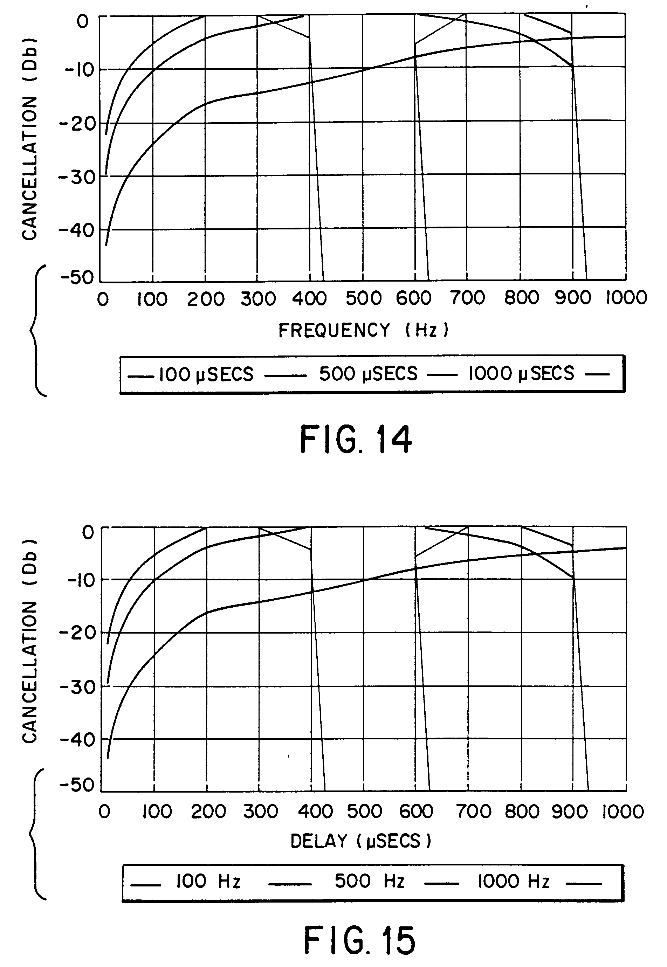

In figures 14 and 15 the amount of cancellation is plotted for various frequencies and time delays. The plots are, of course, the same with frequency and delay interchanged since the amount of cancellation depends on the product of the two. Note that complete cancellation of the sinusoidal noise is obtained whenever the product of the frequency, in Hz, and the delay, in seconds, is an integer multiple of 0.5 cycles.

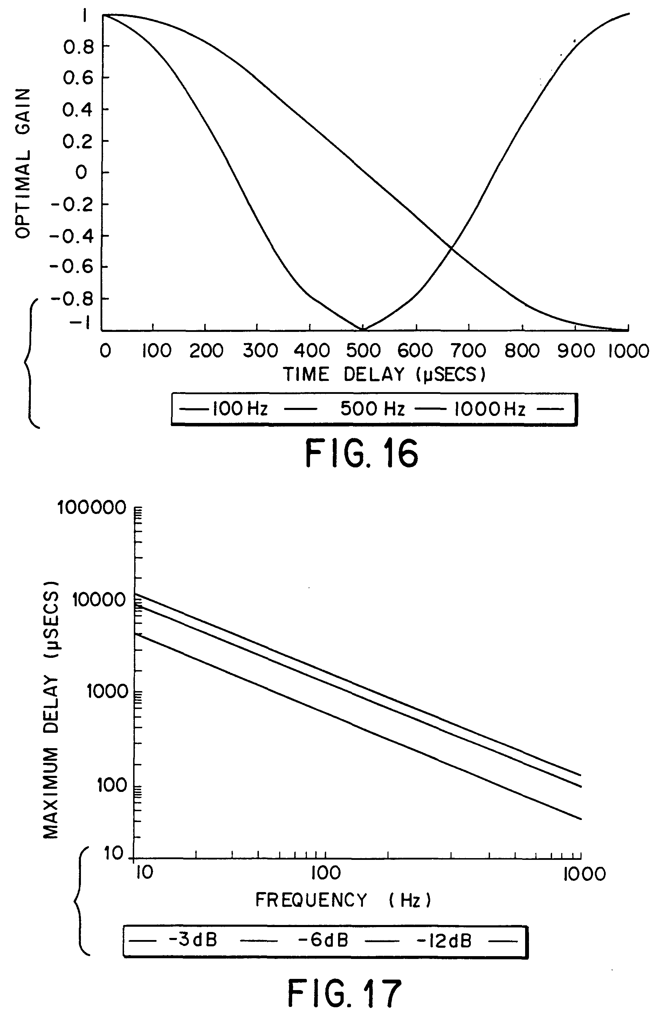

The value of $A_{opt}$ is shown for various frequencies and time delays in figure 16. Again, the values of frequency and time delay can be interchanged. When either the frequency or time delay is low, e.g., 100 Hz or 100 μsecs, the optimal gain is relatively independent of the other variable. However, when both increase the optimal gain can swing from +1 to -1.

A feel for the implications of these results can be obtained by solving for the maximum plant delay at various frequencies for selected amounts of cancellation. These are listed in table 1 and shown in figure 17 using optimal gain.

Table 1 .

| Maximum Delay vs Frequency and Minimum Cancellation | | | |
|---|---|---|---|
| Maximum Delay (μsecs) | | | |
| Frequency (Hz) | 3 dB Cancellation | 6 dB Cancellation | 12 dB Cancellation |
| 100 | 1,253 | 836 | 404 |
| 500 | 251 | 167 | 81 |
| 1000 | 125 | 84 | 40 |

A specification for the plant design can be obtained by the use of equations 5 and 7. In order to have constant gain with a flat frequency response the product $\omega\, t_d$ must be constant; call it K.

$$K = \omega\, t_d \qquad\qquad \text{Eq. (8)}$$

The value of K can be determined by selecting a desired amount of cancellation and applying equation 7 as follows:

$$K = \sin^{-1}\left[\ \log^{-1}\left[\ \frac{dB_{des}}{20}\ \right]\right] \qquad\qquad \text{Eq. (9)}$$

Table 2 show the values of K and the resulting gains for 3 dB, 6 dB and 12 dB of cancellation.

Table 2.

| K and A vs Desired Cancellation | | |
|---|---|---|
| Cancellation | K | A |
| 3 dB | 0.787 | 0.71 |
| 6 dB | 0.525 | 0.87 |
| 12 dB | 0.254 | 0.97 |

Applying equation 8 gives the required delay at each frequency. Solving the equation

$$td = -\ \frac{d\theta}{d\omega} \qquad\qquad \text{Eq. (10)}$$

for phase provides the required phase response

$$\theta = -K \ln (\omega) \qquad\qquad \text{Eq. (11)}$$

Figure 18 shows the required phase response for three different levels of cancellation. The phase response for the required amount of cancellation and flat magnitude frequency response provide the specification for the optimum plant.

This analysis applies a random cancellation technique to sinusoidal noise in order to assess the effects of time delays in the plant. Relationships are derived that determine the optimal gain and the amount of cancellation for various combinations of frequency and plant delay. The maximum plant delay allowable in order to achieve certain cancellation goals is tabulated. Design rules are presented to determine the optimum plant response.

EOUALIZING FILTER

The low-cost noise cancellation system consists of a microphone, a speaker and signal processing to minimize the noise at the microphone. The speaker is modeled as a discrete transfer function h(z) along with a discrete time delay $z^{-d}$ of d samples. The basic system is as follows:

$$n$$

$$z^d\,h\,(z) \longrightarrow \Sigma \longrightarrow$$

$$+$$

$$— z^{-d}\,(est\;h\,(z)) \longrightarrow \Sigma$$

$$1$$

$$-1$$

The canceling signal appears at 1. This signal goes through the time delay and speaker to be mixed with the noise n. It also goes through an FIR estimate of the speaker h(z) with the appropriate time delay. This configuration results in the canceling signal being subtracted from the noise n before the inversion block. Thus, the noise n itself is inverted and outputs as the canceling signal.

The problem with this configuration is the canceling signal phase shift caused by both the time delay d and the speaker h(z). For a low cost canceller it is counter productive to design in predictors to predict the noise d samples into the future. Rather it was initially thought to compensate the canceling signal at point 1. The form of this compensation would be one over the estimate of h(z). Nothing can be done about the delay other than increasing the sampling rate to minimize its effects. Here, two filters along with A/D's and D/A's are needed.

This invention contemplates a configuration that compensates for the phase shifts in the speaker but needs only one filter and associated hardware. The compensation here consists of the inverse estimate of the speaker. Here the canceling signal is sent to the speaker and the time delay feedback function. The signal is degraded by the speaker and then has noise added to it. This resultant signal is then compensated. This output is added to the negated, delayed only canceling signal. The result is n only going to the inverter as before.

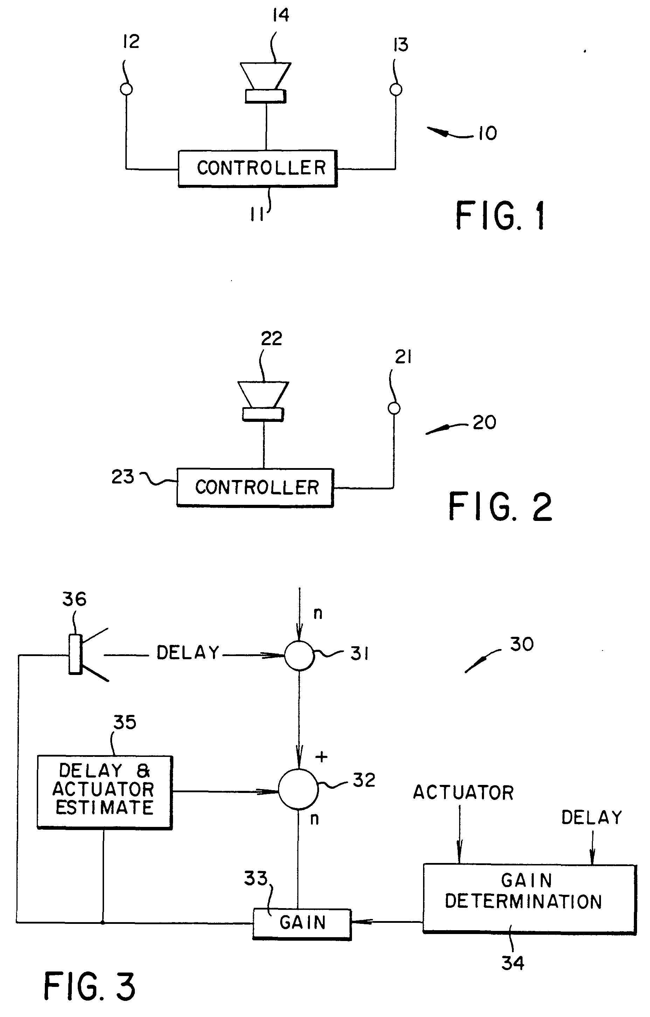

Many cancellation schemes have been developed such as that in Fig. 1 denoted as 10 which uses a reference microphone 12, a speaker actuator 14, controller 11 and an error microphone 13. A substantial amount of signal processing including adaptive filtering is done in the processor. A simplification to this scheme is seen in Fig. 2 at 20. Here, one error microphone 21 and actuator 22 along with controller 23 having the necessary signal processing duel adaptive filtering are required. However, even with pretraining two of the adaptive filters, one multiweight adaptive filter is constantly having its weight values updated which still involves a nontrivial amount of signal processing.

Low Cost Controller Derivation

The new system is a simplified solution of an optimum Weiner filter with a single gain inversion process that is calculated with a knowledge of the input noise statistics and the plant characteristics. This system is seen in Figure 3 as 30 with a feedback filter (an estimate of the delay and plant characteristic) to subtract out the effect of the canceling signal. It has Gain Determinator 34, actuator 36, input 31, summing module 32, the gain 33, delay and actuator estimate and actuator 35. Thus, the residual is simply the resultant noise following cancellation. Note that the feedback filter is dependent only on the delay and actuator and needs to be determined only once, such as with a white noise training signal.

The feedback filter is the impulse response of the actual actuator with delay included and can be measured experimentally with an analyzer.

The optimum filter is a realization of the well known projection theorem found in many stochastics processes texts. Note that this filter is possible only with the perfect subtraction of the canceling signal. It can be shown that the optimum gain is such a filter is

$$\text{gain opt} = <u,n>/<u,u>$$

Where n is the input noise to be canceled and u is that noise filtered through the delay and actuator. <> is expectation and the gain equation reduces to

gain opt = cross correlation of n and filtered n at delay divided by the auto correlation of filtered n

Therefore, the primary disadvantage to the low cost scheme is readily apparent - the transport delay can cause the optimum gain to be so low as to effect no cancellation of n. However, given a reasonable delay, say 2 sample periods, cancellation can be effected if the cross correlation at 2 is not too small. So, white noise cannot be canceled with this scheme but correlated signals, especially those whose frequency is much less than the digital sampling frequency can be significantly reduced.

Equalization of Plant

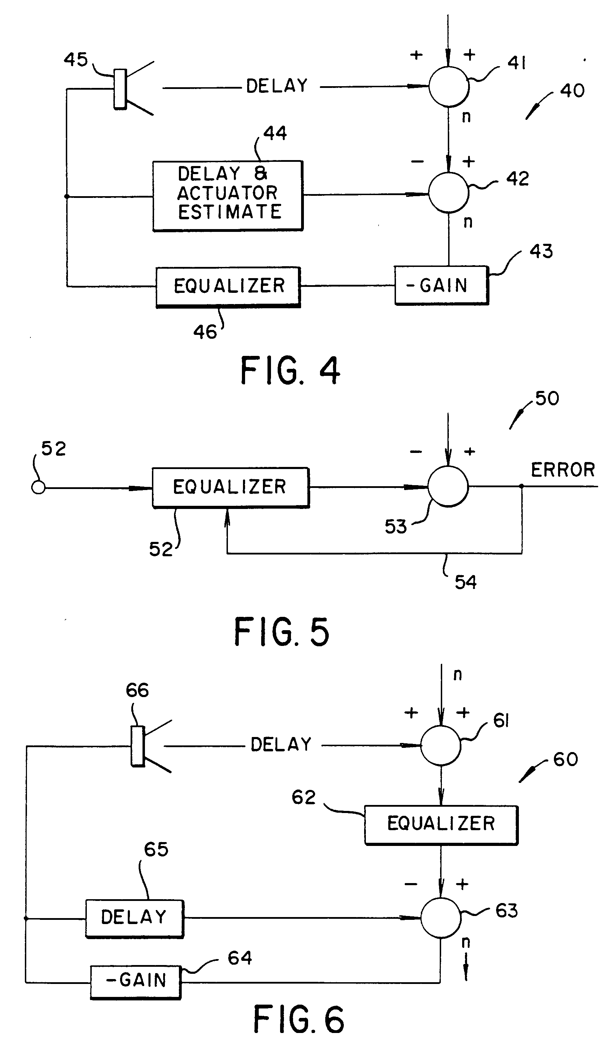

An improvement to the new system is realized with an equalizer placed after the gain block as in Figure 4 as 40 having modules input 41, summer 42, gain 43, equalizer 46, delay and actuator estimator 44 and actuator 45.

The equalizer 46 is determined analytically or adaptively (such as with a white noise training signal). A conventional equalizer would be trained so that the convolution of the equalizer and actuator is an impulse. However, for this control system application, the resulting delay is unacceptable. So, given an impulse response of interest, the equalizer is trained to produce the correct phase shift at frequencies of interest. As with a feedback filter, the equalizer is dependent only on the actuator and need be determined only once for a given plant. Thus the signal processing is reduced to two filters only with no filter weight adaption processing necessary during operation.

This unique equalizer is trained as in Fig. 5. The input is the set of frequencies to be corrected. The frequency response of the plant will give the phase shift and magnitude response through the plant. Then determine the frequencies to be equalized (from a knowledge of the noise to be canceled) and construct the input to the training process. Additional emphasis may be given to the specific frequencies of interest by increasing their relative magnitude going into the equalizer. Note also that frequencies that should not be canceled such as voice or alarms may have their phases shifted so as to add constructively at the microphone and ensure their being heard.

This scheme in Fig. 4 works well but requires two sets of A/D's and D/A's to support the two digital filters. An alternative scheme was devised to further reduce the hardware requirements in this low cost canceling approach.

Single Filter Equalization

A further improvement in the way of hardware reduction is seen in Fig. 6 as 60 with modules input 61, summer 63, equalizer 62, gain 64, delay only 65 and actuator 66.

Here, the equalizer 62 is placed after the microphone and before the subtraction of the canceling signal. The feedback filter is reduced to a delay only; the equalizer 62 produces the corrected version of the canceling signal still incorporating the delay at the feedback cancellation point. Therefore, only one digital filter with a simple delay feedback filter is needed in this low-cost implementation.

Training the equalizer is identical to the two filter canceller above and the equalizing filter produced is identical. Note that the residual before the gain inverter is now not the noise itself but an equalized version of the noise. The residual still has the canceling signal subtracted from it though. The feedback delay can be adjusted to give the best cancellation when the plant delay is uncertain. Obtaining the impulse response with the analyzer in the lab usually give a good indication of the delay - the time of the first peak corresponds to the delay.

The two filter configuration is much less sensitive to the equalizer than the single filter equalizer due to a good noise sample always being present just before the inversion process. In the one filter case, an equalized version of the noise was present at the inverter. This example was with plant of 100 weights and an equalizer of 32 and then 100 weights. A different plant with a more over damped step response, shorter transport delay, longer equalizer or noise with different statistics may make the one filter case practical.

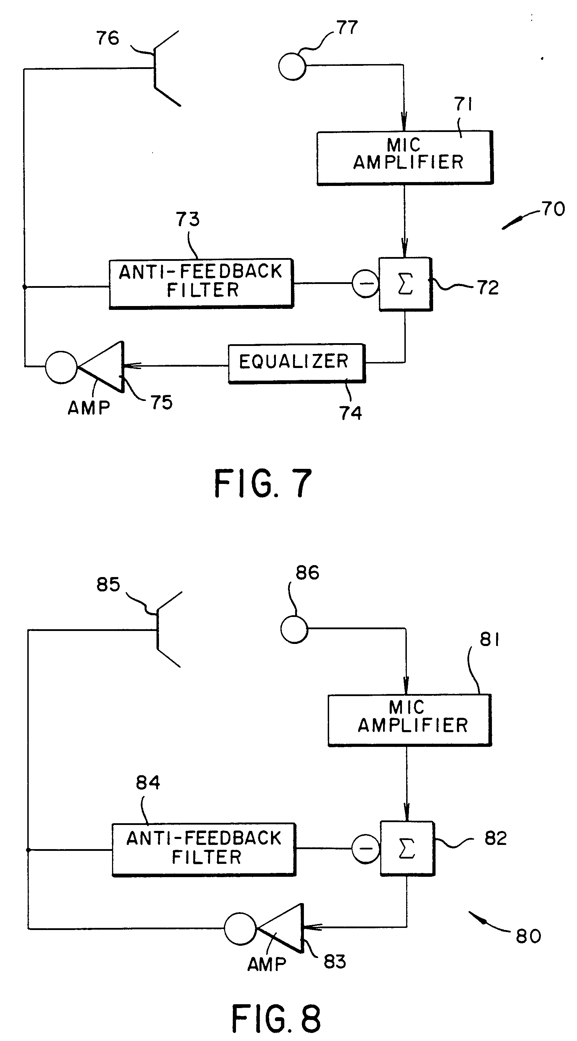

A sample low cost canceller with plant equalizations shown in Fig. 7 as 70 with microphone 77, amplifier 71, summer 72, filter 73, equalizer 74 and adjustable gain amplifier 75.

Fig. 8 shows basic low cost canceller 80 with microphone 86, amplifier 81, summation 82, filter 84 and amplifier 83. The use of a single filter low cost canceller with equalization is shown as 90 with equalization feedback cancellation 91, summer 92, delay 93, amplifier 94, actuator 95 and microphone 96.

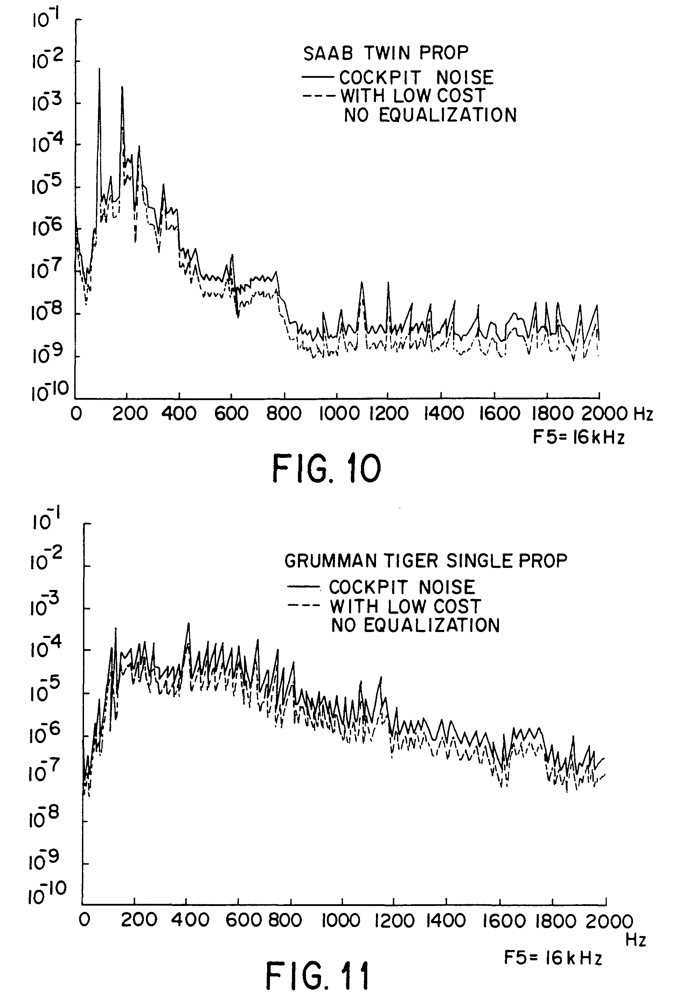

Fig. 10 shows the plot for a prop plane noise where the gain was adjusted for optimum performance once the feedback filter was loaded. The peak reduction was 10 dB for the lowest harmonic and approximately 5 dB for the next lowest.

Fig. 11 shows the plot for a single engine having a broader spectrum without high peaks at low frequency. The reduction was 3 - 5 dB across the spectrum.

**Claims**

1. A low cost active noise control system (30, 40, 60, 70, 80, 90) for cancelling band-limited random noise in a physical plant, comprising:

   a speaker means (36, 45, 66, 76, 85, 95) which, responsive to a control signal, generates a sound field thereby producing a residual noise equal to the sum of said sound field and said band-limited random noise,
   an error sensing means (31, 41, 61, 77, 86, 96) which senses the residual noise and generates a residual signal representative of said residual noise,

   characterized in that it further comprises

   a controller means responsive to a corrected signal which generates said control signal, whereby this controller means comprises
   a single amplifier means (33, 43, 64, 75, 83, 94) having an adjustable gain which may be positive or negative and for amplifying said corrected signal,
   a compensation means (35, 44, 65, 73, 84, 93), which, responsive to said control signal, produces a compensation signal, and
   a subtraction means (32, 42, 63, 72, 82, 92) which subtracts said compensation signal from said residual signal to produce said corrected signal whereby the speaker operates to cancel said band-limited random noise.

2. A system (40) as in claim 1, wherein said controller means includes an equalization filter means (46), whereby amplifier (43) and equalizing means (46) are adapted to compensate for delays that are too long for random cancellation.

3. A system as in claim 1 or 2, wherein said error sensing means (31, 41, 61, 77, 86, 96) is a microphone.

4. A system (60) as in claim 1 which further comprises:

   an equalization filter (62) which receives said residual signal and produces an equalized residual signal and which compensates for a frequency-amplitude response of said physical plant,
   wherein said compensation signal is subtracted from said equalized residual signal to produce said corrected signal.

5. A system (60) as in claim 4, wherein said compensation means is a delay means (65) which causes a delay substantially equal to a delay introduced by a combination of said equalization filter (62) and said physical system.

6. A system (40) as in claim 1 which further comprises an equalization filter (46) which receives said control signal and produces an equalized control signal, wherein said equalization filter (46) compensates for a frequency amplitude response of said physial plant and wherein said speaker means (45) is responsive to said equalized control signal.

7. A System as in claim 6, wherein said compensation means is a delay means (44) which causes a delay substantially equal to a delay introduced by a combination of said equalization filter (46) and said physical system, and wherein said subtracting means (42) subtracts said compensaiton signal from said residual signal to produce said correction said.

8. A system (60) as in claim 1 , wherein said compensation means is a digital filter (65) having a response substantially equal to a response of said physical plant in the frequency range of said band-limited random noise.

9. A method for cancelling band-limited random noise in a physical plant comprising the steps of:

generating a sound field in response to a control signal thereby producing a residual noise equal to the sum of said sound field and said band-limited random noise,
sensing the residual noise and generating a residual signal which is representative of the residual noise,

characterized by that it further comprises the steps of

generating said control signal by amplifying a corrected signal according to an adjustable gain which may be positive or negative,
generating a compensation signal in response to said control signal, subtracting said compensation signal from said residual signal to produce said corrected signal
whereby said sound field operates to cancel said band-limited random noise.

10. A method as in claim 9, wherein the step of sensing the residual noise is done with microphones.

11. The method of claim 9 or 10, further comprising the steps of:
equalizing said residual signal, thereby compensating for a frequency-amplitude response of said physical plant, to produce an equalized residual signal, wherein said compensation signal is subtracted from said equalized residual signal to produce said corrected signal.

12. The method of claim 11, wherein said compensation signal is obtained by delaying said control signal by an amount substantially equal to a delay introduced by a combination of an equalization filter (62) which produces said equalized residual signal and said physical plant.

13. The method of claim 9 further comprising the step of: equalizing said control signal thereby compensating for a frequency amplitude response of said physical plant, to produce an equalized control signal, wherein said compensation signal is generated from said equalized control signal and is subtracted from said residual signal to produce said corrected signal.

14. The method of claim 13, wherein said compensation signal is obtained by delaying said control signal by an amount substantially equal to a delay introduced by a combination of an equalization filter (62) which produces said equalized control signal and said physical plant.

15. The method of claim 9, wherein said compensation signal is obtained by passing said control signal through a digital filter (65) with a response substantially equal a response of said physical plant in the frequency range of said band-limited random noise.


**Patentansprüche**

1. Preisgünstiges aktives Rauschsteuersystem (30, 40, 60, 70, 80, 90) zum Löschen von bandbegrenztem Zufallsrauschen in einer physikalischen Anlage mit:

einem Lautsprechermittel (36, 45, 66, 76, 85, 95), das in Reaktion auf ein Steuersignal ein Schallfeld erzeugt, wodurch ein Restrauschen gleich der Summe des Schallfeldes und des bandbegrenzten Zufallsrauschens erzeugt wird,

einem Fehlererfassungsmittel (31, 41, 61, 77, 86, 96), welches das Restrauschen erfasst und ein Restsignal erzeugt, das repräsentativ für das Restrauschen ist,

dadurch gekennzeichnet, dass es des Weiteren beinhaltet:

ein Steuermittel, das auf ein korrigiertes Signal reagiert und das Steuersignal erzeugt, wobei dieses Steuermittel beinhaltet:

ein einziges Verstärkermittel (33, 43, 64, 75, 83, 94) mit einer einstellbaren Verstärkung, die positiv oder negativ sein kann, zum Verstärken des korrigierten Signals,

ein Kompensationsmittel (35, 44, 65, 73, 84, 93), das in Reaktion auf das Steuersignal ein Kompensationssignal erzeugt, und

ein Subtraktionsmittel (32, 42, 63, 72, 82, 92), welches das Kompensationssignal von dem Restsignal subtrahiert, um das korrigierte Signal zu erzeugen, wobei der Lautsprecher dahingehend wirkt, das bandbegrenzte Zufallsrauschen zu löschen.

2.  System (40) nach Anspruch 1, wobei das Steuermittel ein Entzerrerfiltermittel (46) beinhaltet, wobei der Verstärker (43) und das Entzerrermittel (46) dafür ausgelegt sind, Verzögerungen zu kompensieren, die für Zufallslöschung zu lang sind.

3.  System nach Anspruch 1 oder 2, wobei das Fehlererfassungsmittel (31, 41, 61, 77, 86, 96) ein Mikrophon ist.

4.  System (60) nach Anspruch 1, das des Weiteren beinhaltet:

    ein Entzerrerfilter (62), welches das Restsignal empfängt und ein entzerrtes Restsignal erzeugt und das eine Frequenzamplitudenantwort der physikalischen Anlage kompensiert,

    wobei das Kompensationssignal von dem entzerrten Restsignal subtrahiert wird, um das korrigierte Signal zu erzeugen.

5.  System (60) nach Anspruch 4, wobei das Kompensationsmittel ein Verzögerungsmittel (65) ist, das eine Verzögerung bewirkt, die im Wesentlichen gleich einer Verzögerung ist, die durch eine Kombination des Entzerrerfilters (62) und des physikalischen Systems eingebracht wird.

6.  System (40) nach Anspruch 1, das des Weiteren ein Entzerrerfilter (46) beinhaltet, welches das Steuersignal empfängt und ein entzerrtes Steuersignal erzeugt, wobei das Entzerrerfilter (46) eine Frequenzamplitudenantwort der physikalischen Anlage kompensiert und wobei das Lautsprechermittel (45) auf das entzerrte Steuersignal reagiert.

7.  System nach Anspruch 6, wobei das Kompensationsmittel ein Verzögerungsmittel (44) ist, das eine Verzögerung bewirkt, die im Wesentlichen gleich einer Verzögerung ist, die durch eine Kombination des Entzerrerfilters (46) und des physikalischen Systems eingebracht wird, und wobei das Subtraktionsmittel (42) das Kompensationssignal von dem Restsignal subtrahiert, um das Korrektursignal zu erzeugen.

8.  System (60) nach Anspruch 1, wobei das Kompensationsmittel ein digitales Filter (65) mit einer Antwort ist, die im Wesentlichen gleich einer Antwort der physikalischen Anlage in dem Frequenzbereich des bandbegrenzten Zufallsrauschens ist.

9.  Verfahren zum Löschen von bandbegrenztem Zufallsrauschen in einer physikalischen Anlage, das die Schritte umfasst:

    Erzeugen eines Schallfeldes in Reaktion auf ein Steuersignal, wobei ein Restrauschen erzeugt wird, das gleich der Summe des Schallfeldes und des bandbegrenzten Zufallsrauschens ist,

    Erfassen des Restrauschens und Erzeugen eines Restsignals, das repräsentativ für das Restrauschen ist,

dadurch gekennzeichnet, dass es des Weiteren die Schritte umfasst:

    Erzeugen des Steuersignals durch Verstärken eines korrigierten Signals gemäß einer einstellbaren Verstärkung, die positiv oder negativ sein kann,

    Erzeugen eines Kompensationssignals in Reaktion auf das Steuersignal, Subtrahieren des Kompensationssignals von dem Restsignal, um das korrigierte Signal zu erzeugen,

    wobei das Schallfeld dahingehend wirkt, das bandbegrenzte Zufallsrauschen zu löschen.

10. Verfahren nach Anspruch 9, wobei der Schritt des Erfassens des Restrauschens mit Mikrophonen bewerkstelligt wird.

11. Verfahren nach Anspruch 9 oder 10, das des Weiteren die Schritte umfasst:
Entzerren des Restsignals, wodurch eine Frequenzamplitudenantwort der physikalischen Anlage kompensiert wird, um ein entzerrtes Restsignal zu erzeugen, wobei das Kompensationssignal von dem entzerrten Restsignal subtrahiert wird, um das korrigierte Signal zu erzeugen.

12. Verfahren nach Anspruch 11, wobei das Kompensationssignal erhalten wird, indem das Steuersignal um einen Betrag verzögert wird, der im Wesentlichen gleich einer Verzögerung ist, die durch eine Kombination eines Entzerrerfilters (62), welches das entzerrte Restsignal erzeugt, und der physikalischen Anlage eingebracht wird.

13. Verfahren nach Anspruch 9, das des Weiteren die Schritte umfasst:
Entzerren des Steuersignals, wodurch eine Frequenzamplitudenantwort der physikalischen Anlage kompensiert wird, um ein entzerrtes Steuersignal zu erzeugen, wobei das Kompensationssignal von dem entzerrten Steuersignal erzeugt wird und von dem Restsignal subtrahiert wird, um das korrigierte Signal zu erzeugen.

14. Verfahren nach Anspruch 13, wobei das Kompensationssignal erhalten wird, indem das Steuersignal um einen Betrag verzögert wird, der im Wesentlichen gleich einer Verzögerung ist, die durch eine Kombination eines Entzerrerfilters (62), welches das entzerrte Steuersignal erzeugt, und der physikalischen Anlage eingebracht wird.

15. Verfahren nach Anspruch 9, wobei das Kompensationssignal erhalten wird, indem das Steuersignal durch ein digitales Filter (65) mit einer Antwort hindurchgeleitet wird, die im Wesentlichen gleich einer Antwort der physikalischen Anlage in dem Frequenzbereich des bandbegrenzten Zufallsrauschens ist.

## Revendications

1. Système économique de commande de bruit actif (30, 40, 60, 70, 80, 90) destiné à annuler un bruit aléatoire à bande limitée dans une installation physique, comprenant :

    un moyen de haut-parleur (36, 45, 66, 76, 85, 95) qui, en réponse à un signal de commande, génère un champ sonore en produisant ainsi un bruit résiduel égal à la somme dudit champ sonore et dudit bruit aléatoire à bande limitée,
    un moyen de détection d'erreur (31, 41, 61, 77, 86, 96) qui détecte le bruit résiduel et génère un signal résiduel représentatif dudit bruit résiduel,

    caractérisé en ce qu'il comprend en outre

    un moyen de contrôleur répondant à un signal corrigé qui génère ledit signal de commande, d'où il résulte que ce moyen de contrôleur comprend
    un seul moyen d'amplificateur (33, 43, 64, 75, 83, 94) présentant un gain ajustable qui peut être positif ou négatif et destiné à amplifier ledit signal corrigé,
    un moyen de compensation (35, 44, 65, 73, 84, 93) qui, en réponse audit signal de commande, produit un signal de compensation, et
    un moyen de soustraction (32, 42, 63, 72, 82, 92) qui soustrait ledit signal de compensation dudit signal résiduel afin de produire ledit signal corrigé d'où il résulte que le haut-parleur fonctionne de façon à annuler ledit bruit aléatoire à bande limitée.

2. Système (40) selon la revendication 1, dans lequel ledit moyen de contrôleur comprend un moyen de filtre d'égalisation (46), grâce à quoi un amplificateur (43) et un moyen d'égalisation (46) sont adaptés pour compenser des retards qui sont trop longs pour une annulation aléatoire.

3. Système selon la revendication 1 ou 2, dans lequel ledit moyen de détection d'erreur (31, 41, 61, 77, 86, 96) est un microphone.

4. Système (60) selon la revendication 1, qui comprend en outre :

un filtre d'égalisation (62) qui reçoit ledit signal résiduel et produit un signal résiduel égalisé et qui compense une réponse fréquence-amplitude de ladite installation physique,

dans lequel ledit signal de compensation est soustrait dudit signal résiduel égalisé afin de produire ledit signal corrigé.

**5.** Système (60) selon la revendication 4, dans lequel ledit moyen de compensation est un moyen à retard (65) qui provoque un retard sensiblement égal à un retard introduit par une combinaison dudit filtre d'égalisation (62) et dudit système physique.

**6.** Système (40) selon la revendication 1, qui comprend en outre un filtre d'égalisation (46) qui reçoit ledit signal de commande et produit un signal de commande égalisé, dans lequel ledit filtre d'égalisation (46) compense une réponse fréquence-amplitude de ladite installation physique et dans lequel ledit moyen de haut-parleur (45) est sensible audit signal de commande égalisé.

**7.** Système selon la revendication 6, dans lequel ledit moyen de compensation est un moyen à retard (44) qui provoque un retard sensiblement égal à un retard introduit par une combinaison dudit filtre d'égalisation (46) et dudit système physique,

et dans lequel ledit moyen de soustraction (42) soustrait ledit signal de compensation dudit signal résiduel afin de produire ledit signal de correction.

**8.** Système (60) selon la revendication 1, dans lequel ledit moyen de compensation est un filtre numérique (65) présentant une réponse sensiblement égale à une réponse de ladite installation physique dans la plage de fréquence dudit bruit aléatoire à bande limitée.

**9.** Procédé destiné à annuler un bruit aléatoire à bande limitée dans une installation physique comprenant les étapes consistant à :

générer un champ sonore en réponse à un signal de commande en produisant ainsi un bruit résiduel égal à la somme dudit champ sonore et dudit bruit aléatoire à bande limitée,

détecter le bruit résiduel et générer un signal résiduel qui est représentatif du bruit résiduel,

caractérisé en ce qu'il comprend en outre les étapes consistant à

générer ledit signal de commande en amplifiant un signal corrigé conformément à un gain ajustable qui peut être positif ou négatif,

générer un signal de compensation en réponse audit signal de commande, soustraire ledit signal de compensation dudit signal résiduel afin de produire ledit signal corrigé

d'où il résulte que ledit champ sonore fonctionne pour annuler ledit bruit aléatoire à bande limitée.

**10.** Procédé selon la revendication 9, dans lequel l'étape de détection du bruit résiduel est exécutée avec des microphones.

**11.** Procédé selon la revendication 9 ou 10, comprenant en outre les étapes consistant à :

égaliser ledit signal résiduel, en compensant ainsi une réponse fréquence/amplitude de ladite installation physique, afin de produire un signal résiduel égalisé, dans lequel ledit signal de compensation est soustrait dudit signal résiduel égalisé afin de produire ledit signal corrigé.

**12.** Procédé selon la revendication 11, dans lequel ledit signal de compensation est obtenu en retardant ledit signal de commande d'une valeur sensiblement égale à un retard introduit par une combinaison d'un filtre d'égalisation (62) qui produit ledit signal résiduel égalisé et de ladite installation physique.

**13.** Procédé selon la revendication 9, comprenant en outre les étapes consistant à : égaliser ledit signal de commande en compensant ainsi une réponse fréquence-amplitude de ladite installation physique, afin de produire un signal de commande égalisé, dans lequel ledit signal de compensation est généré à partir dudit signal de commande égalisé et est soustrait dudit signal résiduel afin de produire ledit signal corrigé.

**14.** Procédé selon la revendication 13, dans lequel ledit signal de compensation est obtenu en retardant ledit signal de commande d'une valeur sensiblement égale à un retard introduit par une combinaison d'un filtre d'égalisation

**EP 0 659 288 B1**

(62) qui produit ledit signal de commande égalisé et de ladite installation physique.

15. Procédé selon la revendication 9, dans lequel ledit signal de compensation est obtenu en transmettant ledit signal de commande par l'intermédiaire d'un filtre numérique (65) présentant une réponse sensiblement égale à une réponse de ladite installation physique dans la plage de fréquence dudit bruit aléatoire à bande limitée.

FIG. 1

FIG. 2

FIG. 3

FIG. 4

FIG. 5

FIG. 6

76

77

71

MIC
AMPLIFIER

70

73

ANTI-FEEDBACK
FILTER

−  Σ

72

75

AMP

EQUALIZER

74

## FIG. 7

85

86

81

MIC
AMPLIFIER

84

ANTI-FEEDBACK
FILTER

−  Σ

82

80

AMP

83

## FIG. 8

FIG. 9

FIG. 18

SAAB TWIN PROP
—— COCKPIT NOISE
--- WITH LOW COST
    NO EQUALIZATION

F5= 16kHz

FIG. 10

GRUMMAN TIGER SINGLE PROP
—— COCKPIT NOISE
--- WITH LOW COST
    NO EQUALIZATION

F5= 16 kHz

FIG. 11

-20

DBV

LOG

SPEC B STO

CANCELLED

0    NORM   LNX1   BASE   ΔF  1.250 Hz      500.00

422.50 Hz   AVG:-25.7   STO  -39.4 DBV  SPEC  EXP N 100

## FIG. 12

SETUP    GRP SPEC   DUAL   VW 40DB  CH B FR 500 HZ
03:59:00  SPEC B     AVG      DG +40DB  WTG H B 5V
-20 OVE 15 TAPS  8KHZ

-20

DBV

LOG

-60

UNCANCELLED

0        LNXI    BASE     ΔF 1.250  Hz     500.00

## FIG. 13

FIG. 14

FIG. 15

FIG. 16

FIG. 17